# EUROPEAN PATENT SPECIFICATION

(11) **EP 2 196 489 B1**
(45) Date of publication and mention of the grant of the patent: **28.08.2013**
(21) Application number: 08021736.7
(22) Date of filing: 15.12.2008
(51) Int. Cl.: C08G 81/00, C08G 81/02, C08G 83/00, C08F 255/02, C08F 267/04, C08F 267/06, C08L 77/00, C08L 77/02, C08L 77/06, H01L 31/048

(54) **Photovoltaic modules with a backsheet film comprising a polyamide-grafted polymer and manufacturing process and use thereof**
Photovoltaische Module mit einem Unterlagenfilm mit Polyamid-gepfropftem Polymer, Herstellungsverfahren und Verwendung dafür
Modules photovoltaïques avec un film barrière comportant un polymère greffé en polyamide et son procédé de fabrication et utilisation

(43) Date of publication of application: 16.06.2010
(73) Proprietor: ARKEMA FRANCE, 92700 Colombes (FR); Solutia Solar GmbH, 31582 Nienburg/Weser (DE)
(72) Inventor: Vogt, Marc, West Sacramento, CA95605 (US); Jousset, Dominique, 27470 Serquigny (FR); Bizet, Stéphane, 27470 Serquigny (FR); Flat, Jean-Jacques, 27170 Goupillieres (FR)
(74) Representative: Beetz & Partner

(56) References cited:
- WO-A-2008/019229
- GB-A- 1 531 976
- US-A- 3 963 799
- US-A- 3 976 720
- US-A- 5 342 886
- US-A1- 2003 199 635
- US-A1- 2008 041 442

## Description

### Field of the invention

The invention relates to photovoltaic modules, the process for manufacturing these photovoltaic modules and the use thereof.

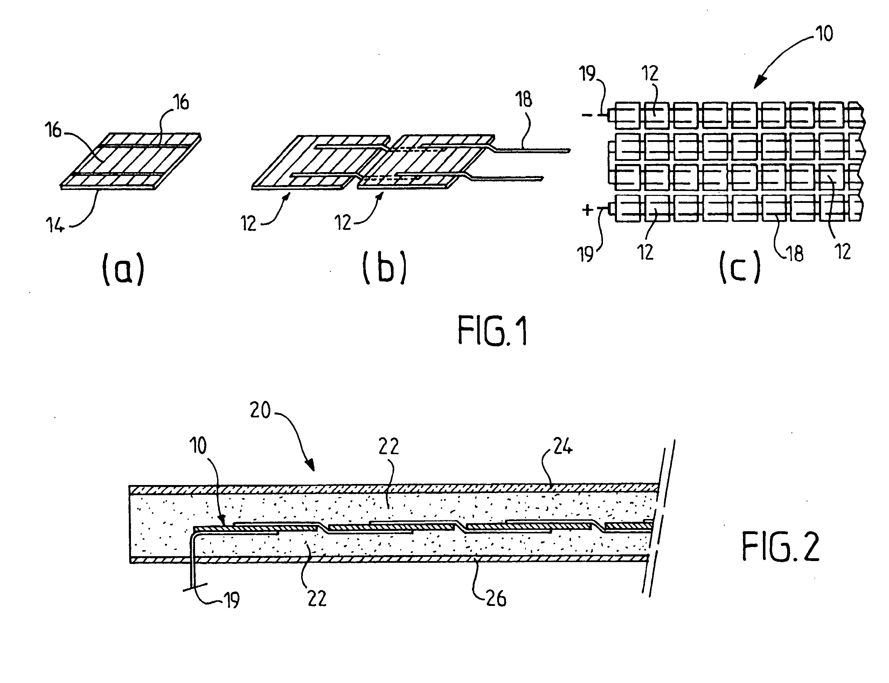

Global warming, linked to the greenhouse gases released by fossil fuels, has led to the development of alternative energy solutions which do not emit such gases during their operation, such as, for example, solar modules. A solar module comprises a "photovoltaic cell", this cell being capable of converting light energy into electricity. In Figure 1, a conventional photovoltaic cell is represented; this photovoltaic cell (10) comprises cells (12), one cell containing a photovoltaic sensor (14), generally based on silicon that is treated in order to obtain photoelectric properties, in contact with electron collectors (16) placed above (upper collectors) and below (lower collectors) the photovoltaic sensor. The upper collectors (16) of one cell are connected to the lower collectors (16) of another cell (12) by conducting bars (18), generally made from an alloy of metals. All these cells (12) are connected together, in series and/or in parallel, to form the photovoltaic cell (10). When the photovoltaic cell (10) is placed under a light source, it delivers a continuous electric current, which may be recovered at the terminals (19) of the cell (10).

With reference to Figure 2, the solar module (20) comprises the photovoltaic cell (10) from Figure 1 encased in an "encapsulant" (22). An upper protective layer (24) and a protective film on the back of the module (26), also known under the name "backsheet", are positioned on both sides of the encapsulated cell.

The encapsulant (22) must perfectly take up the shape of the space existing between the photovoltaic cell (10) and the protective layers (24) and (26) in order to avoid the presence of air and water, which would limit the efficiency of the solar module.

The impact and moisture protection of the photovoltaic cell (10) is provided by the upper protective layer (24), generally made of glass. The protective backsheet film (26), which is an essential component of the present invention, itself contributes to the moisture protection of the solar module (20) and to the electrical insulation of the cells (12).

### Prior art

Conventionally, protective backsheet films comprise at least one fluoropolymer layer. Among the fluoropolymers, mention may be made of polyvinyl fluoride (PVF) or polyvinylidene fluoride (PVDF). These are the solutions that are most widely used commercially. Films that are generally used are fluoropolymer /polyester /fluoropolymer three-layer films. These three-layer films have features that enable them to be used as the backsheet: they are impermeable to moisture, have good creep resistance and also good tear strength. They exhibit good ageing behaviour for visible or ultra-violet radiation and good heat resistance. Finally, their electrical properties (in particular their breakdown voltage) are satisfactory.

However, these films have certain drawbacks: the cost of the materials that make up the three-layer film, in particular that of the fluoropolymer, is significant. Furthermore, the fluoropolymer and the polyester are incompatible: it is therefore necessary to use adhesives between each of the layers to enable the three-layer film to be formed. Moreover, a delamination of the various layers of the protective film is often observed during the use of the photovoltaic module, which may lead to its premature ageing. Furthermore, the fluoropolymer is incompatible with the polyolefin-based encapsulants generally used. Thus a delamination of the protective film of the encapsulant is observed, which causes the infiltration of oxygen or of water into the module and its premature ageing.

Moreover, in order to manufacture the protective film it is necessary to use a process that involves several steps of laminating the various layers of the film, which makes its manufacture complex.

Other three-layer films composed of ethylene vinyl acetate copolymer (EVA)/polyester/fluoropolymer are commonly used as backsheets. The EVA layer makes it possible to obtain a better adhesion of the encapsulant to the protective film.

However, this solution is not completely satisfactory since the adhesion between EVA and the polyester is poor, which requires the presence of adhesive between these layers. Furthermore, during the use of the photovoltaic module, a delamination of the various layers of the protective film is also observed over time, which may lead to the premature ageing of the module. Moreover, the process of manufacturing this multilayer film remains identical to that of the fluoropolymer/polyester/fluoropolymer three-layer film and the lamination of the various layers is obligatory.

Mention may be made of document US 2005/0268961, which describes a photovoltaic cell protected by a film comprising two successive fluoropolymer layers, one having a melting point above 135°C, the other having a melting point below 135°C. This film may be used as a protective backsheet of the photovoltaic module. However, the photovoltaic modules described in this document cannot comprise the conventionally used polyolefin-based encapsulants.

Mention may also be made of Application WO 2007/011580, which describes polyester-based films for the rear protection of a photovoltaic module, this polyester having a good resistance to moisture and to UV rays. A layer of PVF may be joined to the polyester film.

This document does not describe the manufacture of a protective film having good adhesion to conventional polyolefin-based encapsulants. Moreover, when the film is a multilayer film, it is necessary to use adhesives to join the various layers of the film.

Moreover, in Patent US 5 741 370 a protective backsheet film is described that comprises a blend of two ionomers having good barrier properties. The cost of manufacturing this protective film is lower than those based on a fluoropolymer. Moreover, this protective film exhibits very good adhesion to the ionomer-based encapsulants. However, to manufacture photovoltaic modules, the lamination of the various layers is carried out at a temperature that may be around 120°C. At this temperature, the blend of ionomers has insufficient thermomechanical stability, which prevents a high-quality photovoltaic module from being manufactured.

WO 2008/019229A relates to a photovoltaic module for capturing and using solar radiation having, as a transparent glazing, a thermoplastic structural component covered by a thin layer of polyvinylidene fluoride (PVDF). Polyamide-grafted polymers comprising a polyolefin backbone are not mentioned in this document.

US 2003/ 199635 A1 discloses a polyamide block copolymer consisting of a basic polyolefin chain and polyamide grafts which are fixed to the basic chain by the radicals of an unsaturated monomer (X), i.e. a copolymer as it is used in the present invention. The organisation of the polyamide-block graft copolymer and its blending with a polyolefin are discussed. The copolymer is used as an adhesive, for tarpaulins or geomembranes, power cables, telecommunication cables and in the slush moulding process. US 2003/199635 A1 does not mention photovoltaic modules and encapsulants and different films to be used in such photovoltaic modules.

US 2008/0041442 A1 relates to a photovoltaic module comprising the typical elements of a photovoltaic module, including an encapsulation layer and a backsheet layer. The encapsulant layer can consist of a copolymer of ethylene, e. g. in combination with ethylene vinyl acetate. Polyamide-grafted polymers comprising a polyolefin backbone are not mentioned in US 2008/0041442 A1.>

Thus, it is therefore necessary to find novel photovoltaic modules that can be manufactured more easily. More particularly, it is necessary for the protective backsheet films to have good adhesion to the conventionally used polyolefin-based encapsulants. The protective backsheet films must have sufficient properties as regards the following: thermomechanical stability at the manufacturing temperature of the photovoltaic module, UV resistance, heat resistance, water vapour permeability and electrical properties.

The above object is achieved according to the independent claims. The dependent claims relate to preferred embodiments of the concept of the present invention.

### Summary of the invention

One subject of the invention is precisely the use of a film of a particular structure as a protective backsheet film for a photovoltaic module that allows the above drawbacks to be overcome.

More precisely, the invention relates to the use of a film as a protective backsheet film for a photovoltaic module, that film comprising at least one layer of a composition containing a polyamide-grafted polymer. The polyamide-grafted polymer comprises a polyolefin backbone containing a residue of at least one unsaturated monomer (X) and at least one polyamide graft, in which:
- the residue of the unsaturated monomer (X) is attached to the backbone by grafting or copolymerization;
- the residue of the unsaturated monomer (X) comprises a functional group capable of reacting via a condensation reaction with a polyamide having at least one amine end group and/or at least one carboxylic acid end group;
- the polyamide graft is attached to the polyolefine backbone by the residue of the unsaturated monomer (X);
- the polyamide graft comprises at least one amine and/or carboxylic acid functional group;
- one amine or acid functional group of the polyamide graft having reacted via a condensation reaction with the residue (X);
the polyamide-grafted polymer comprises, relative to its total weight:
• 40 to 95% by weight of the polyolefin backbone comprising the unsaturated monomer (X); and
• 5 to 60% by weight of polyamide grafts,
the melting point or glass transition temperature of the polyamide grafts being greater than or equal to 85°C.

The use of the protective film makes it possible to give the photovoltaic module very advantageous thermomechanical stability, UV resistance, heat resistance, water vapour permeability and electrical properties. Moreover, the excellent adhesion of the protective film to the other layers of the photovoltaic panel, and in particular to the polyolefin-based encapsulants, makes it possible to limit the penetration of products, such as oxygen or water, inside the module and to thus increase the service life of this module.

Preferably, the unsaturated monomer (X) is an acid anhydride functional group.

Advantageously, at least some of the polyamide grafts are monofunctionalized primary amines. Preferably, the quantity in mass of the monofunctionalized primary amines polyamide grafts is more than 50% of the total quantity of the polyamide grafts and even more preferably more than 75%.

The expression "monofunctionalized primary amine polyamide graft" is understood to mean a polyamide graft bearing a single terminal primary amine function.

The polyamide-grafted polymer advantageously comprises between 10 and 50%, preferably between 20 and 40%, most preferably 25 to 35%, by weight of polyamide grafts relative to its total weight.

Preferably, the melting point or glass transition temperature of the polyamide grafts is greater than or equal to 130°C, for example within the range from 140 to 350°C.

When the melting point or glass transition temperature of the polyamide grafts is within this range, the modules according to the invention have excellent properties. In particular, the thermomechanical properties of the lower protective film allow the module to be manufactured by laminating under conventional manufacturing conditions, that is to say at a temperature of around 120°C.

Preferably, the composition of the invention is nanostructured. According to the invention, the expression "nanostructured composition" is understood to mean a composition comprising at least two immiscible phases, of which at least one of these phases has one of its dimensions (or more than one) below 780 nm. Advantageously, this dimension is below 380 nm, for example in the range from 1 to 380 nm and better still from 10 to 300 nm. The dimensions of the phases may be easily measured by a person skilled in the art using the known technique of transmission electron microscopy and standard image treatment software. Advantageously, with a view to obtaining a good nanostructuring of the polyamide-grafted polymer, use is made, as the molecular weight of the polyamide grafts, of a number-average molecular weight within the range from 1000 to 5000 g/mol, preferably within the range from 2000 to 3000 g/mol. When the composition is nanostructured, the protective film has improved properties compared to a film comprising a non-nanostructured polyamide-grafted polymer composition.

The polyamide grafts may be chosen from homopolyamides such as PA-6, PA-6.6, PA-6.T, PA-9.T, PA-10.T, PA-10.10, PA-10.12, PA-11, PA-12, and copolyamides, such as PA-6/11, PA-6 / 12 and PA-6/11/12.

Preferably, the number of unsaturated monomers (X) attached to the polyolefin backbone is greater than or equal to 1.3 and less than or equal to 10.

Advantageously, the polyolefin backbone is a copolymer comprising an unsaturated monomer (X), preferably an ethylene/alkyl (meth)acrylate copolymer comprising an unsaturated monomer (X).

According to one embodiment of the invention, the composition comprises, in addition, a complementary polymer chosen from polyolefins and polyamides, which is different from the polyolefin backbone and from the polyamide graft.

Preferably, the composition comprises at least 50% by weight of polyamide-grafted polymer.

The composition may comprise, in addition, at least one additive chosen from crosslinking agents, coupling agents, UV stabilizers, antioxidants, fillers, plasticizers, fire retardants, pigments, dyestuffs and optical brighteners.

Preferably, the protective film has a thickness of less than 20 mm, most preferably within the range from 100 µm to 2000 µm.

According to a first variant of the invention, the protective film is a single-layer film. According to a second variant of the invention, the protective film is a multilayer film comprising at least one layer of the composition.

According to the invention, the module, in which the protective film is used, may comprise at least one layer of encapsulant. Advantageously, the encapsulant layer comprises polyolefins. Preferably, the protective backsheet film is in direct contact with the polyolefin-comprising encapsulant.

The protective film according to the invention has a good adhesion with polyolefin-comprising encapsulant.

The invention also relates to a process of manufacturing a photovoltaic module comprising a step of assembling the various layers that constitute the module. Advantageously, the assembly step comprises a laminating stage. Preferably, the laminating stage is carried out at a temperature below the melting point or glass transition temperature of the polyamide grafts.

Another subject of the invention is the use of the photovoltaic module according to the invention under a source of radiation for producing electricity.

### Description of the appended figures

The description which follows is given solely by way of illustration and non-limitingly with reference to the appended figures, in which:
Figure 1, already described, represents an example of a photovoltaic cell, the parts (a) and (b) being ¾ views, part (a) showing a cell before connection and part (b) a view after the connection of 2 cells; part (c) is a top view of a complete photovoltaic cell.
Figure 2, already described, represents a cross section through a solar module.

### Detailed description of the invention

The invention relates to a protective backsheet film used in photovoltaic modules, this film comprising at least one layer of a composition containing a polyamide-grafted polymer, this polyamide-grafted polymer comprising a polyolefin backbone containing a residue of at least one unsaturated monomer (X) and at least one polyamide graft. The composition containing a polyamide-grafted polymer is also known as "cPgP" in the present description.

According to the invention, the polyolefin backbone is a polymer comprising an α-olefin as a monomer.

The α-olefins having from 2 to 30 carbon atoms are preferred. As an α-olefin, mention may be made of ethylene, propylene, 1-butene, 1-pentene, 3-methyl-1-butene, 1-hexene, 4-methyl-1-pentene, 3-methyl-1-pentene, 1-octene, 1-decene, 1-dodecene, 1-tetradecene, 1-hexadecene, 1-octadecene, 1-eicocene, 1-dococene, 1-tetracocene, 1-hexacocene, 1-octacocene, and 1-triacontene. Within the context of the present invention, the term "a-olefin" also includes styrene. Propylene, and most especially ethylene, are preferred as the α-olefin.

This polyolefin may be a homopolymer when a single α-olefin is polymerized in the polymer chain. Mention may be made, as examples, of polyethylene (PE) or polypropylene (PP).

This polyolefin may also be a copolymer when at least two comonomers are copolymerized in the polymer chain, one of the two comonomers known as the "first comonomer" being an α-olefin and the other comonomer, known as the "second comonomer", is a monomer capable of polymerizing with the first monomer.

As the second comonomer, mention may be made of:
- one of the α-olefins already cited, this being different from the first α-olefin comonomer;
- dienes such as, for example, 1,4-hexadiene, ethylidene norbornene and butadiene;
- unsaturated carboxylic acid esters such as, for example, the alkyl acrylates or alkyl methacrylates grouped together under the term alkyl (meth)acrylates. The alkyl chains of these (meth)acrylates may have up to 30 carbon atoms. Mention may be made, as alkyl chains, of methyl, ethyl, propyl, *n-*butyl, *sec*-butyl, isobutyl, *tert*-butyl, pentyl, hexyl, heptyl, octyl, 2-ethylhexyl, nonyl, decyl, undecyl, dodecyl, tridecyl, tetradecyl, pentadecyl, hexadecyl, heptadecyl, octadecyl, nonadecyl, eicosyl, hencosyl, docosyl, tricosyl, tetracosyl, pentacosyl, hexacosyl, heptacosyl, octacosyl and nonacosyl. Methyl, ethyl and butyl (meth)acrylates are preferred as unsaturated carboxylic acid esters; and
- vinyl esters of carboxylic acids. As examples of carboxylic acid vinyl esters, mention may be made of vinyl acetate, vinyl versatate, vinyl propionate, vinyl butyrate or vinyl maleate.

Vinyl acetate is preferred as the carboxylic acid vinyl ester. Advantageously, the polyolefin backbone comprises at least 50 mol% of the first comonomer; its density may advantageously be between 0.91 and 0.96.

The preferred polyolefin backbones are formed from an ethylene/alkyl (meth)acrylate copolymer. By using this polyolefin backbone, an excellent resistance to ageing due to light and to temperature is obtained.

It would not be outside the scope of the invention if various "second comonomers" were copolymerized in the polyolefin backbone. According to the present invention, the polyolefin backbone contains at least one residue of an unsaturated monomer (X) which may react with an acid and/or amine functional group of the polyamide graft via a condensation reaction. According to the definition of the invention, the unsaturated monomer (X) is different of a "second comonomer". As the unsaturated monomer (X) included in the polyolefin backbone, mention may be made of:
- unsaturated epoxides. Among these, there are, for example, aliphatic glycidyl esters and ethers such as allyl glycidyl ether, vinyl glycidyl ether, glycidyl maleate and glycidyl itaconate, glycidyl acrylate and glycidyl methacrylate. These are also, for example, alicyclic glycidyl esters and ethers such as 2-cyclohexene-1-glycidyl ether, cyclohexene-4,5-diglycidylcarboxylate, cyclohexene-4-glycidylcarboxylate, 5-norbornene-2-methyl-2-glycidylcarboxylate and *endocis-*bicyclo[2.2.1]-5-heptene-2,3-diglycidyldicarboxylate. It is preferred to use glycidyl methacrylate as the unsaturated epoxide;
- unsaturated carboxylic acids and salts thereof, for example acrylic acid or methacrylic acid and the salts of these same acids; and
- carboxylic acid anhydrides. They may be chosen, for example, from maleic, itaconic, citraconic, allylsuccinic, cyclohex-4-ene-1,2-dicarboxylic, 4-methylenecyclohex-4-ene-1,2-dicarboxylic, bicyclo[2.2.1]hept-5-ene-2,3-dicarboxylic and x-methylbicyclo[2.2.1]hept-5-ene-2,2-dicarboxylic anhydrides. It is preferred to use maleic anhydride as the carboxylic acid anhydride.

The unsaturated monomer (X) is preferably chosen from an unsaturated carboxylic acid anhydride and an unsaturated epoxide. In particular, to carry out the condensation of the polyamide graft with the polyolefin backbone, in the case where the reactive end group of the polyamide graft is a carboxylic acid functional group, the unsaturated monomer (X) is preferably an unsaturated epoxide. In the case where the reactive end group of the polyamide graft is an amine functional group, the unsaturated monomer (X) is advantageously an unsaturated epoxide and preferably an unsaturated carboxylic acid anhydride.

According to one advantageous version of the invention, the weight ratio of unsaturated monomers (X) attached, on average, to the polyolefin backbone is within the range from 0.5% to 12% relative to the weight of the polyolefin bearing the unsaturated monomer (X). According to another advantageous version of the invention, the preferred number of unsaturated monomers (X) attached, on average, to the polyolefin backbone is greater than or equal to 1.3 and/or preferably less than or equal to 10.

Thus, when (X) is maleic anhydride and the number-average molecular weight of the polyolefin is 15 000 g/mol, it was found that this corresponded to an anhydride proportion of at least 0.8%, and at most 6.5%, by weight of the whole of the polyolefin backbone. These values, combined with the weight of polyamide grafts, determine the proportion of polyamide and of backbone in the polyamide-grafted polymer.

The polyolefin backbone containing the residue of the unsaturated monomer (X) is obtained by polymerization of the monomers (first comonomer, optional second comonomer, and optionally unsaturated monomer (X)). This polymerization may be carried out by a highpressure free-radical process or a process in solution, in an autoclave or tubular reactor, these processes and reactors being well known to a person skilled in the art. When the unsaturated monomer (X) is not copolymerized in the polyolefin backbone, it is grafted to the polyolefin backbone. The grafting is also an operation that is known *per se.* The composition would be in accordance with the invention if several different functional monomers (X) were copolymerized with and/or grafted to the polyolefin backbone.

The functional group of the monomer (X) in the polyolefin backbone can be neutralized with one or more metal cations: in this case, the polyolefin backbone is a ionomer. In this case, the molar quantity of neutralized functional group is preferably less than 30 mol-% of the total functional groups (neutralized and non-neutralized). Preferably, this molar quantity is less than 10 mol-% and most preferably the polyolefin backbone is not a ionomer.

Preferably, the polyolefin has a Melt Flow Index (MFI) between 3 and 400 g/10 min (190°C/ 2.16 kg, ASTM D 1238).

According to the invention, the polyamide grafts may be either homopolyamides or copolyamides.

The expression "polyamide grafts" especially targets the aliphatic homopolyamides which result from the polycondensation:
- of a lactam;
- or of an aliphatic α,ω-aminocarboxylic acid;
- or of an aliphatic diamine and an aliphatic diacid.

As examples of a lactam, mention may be made of caprolactam, oenantholactam and lauryllactam.

As examples of an aliphatic α,ω-aminocarboxylic acid, mention may be made of aminocaproic acid, 7-aminoheptanoic acid, 11-aminoundecanoic acid and 12-aminododecanoic acid.

As examples of an aliphatic diamine, mention may be made of hexamethylenediamine, dodecamethylenediamine and trimethylhexamethylenediamine.

As examples of an aliphatic diacid, mention may be made of adipic, azelaic, suberic, sebacic and dodecanedicarboxylic acids.

Among the aliphatic homopolyamides, mention may be made, by way of example and non-limitingly, of the following polyamides: polycaprolactam (PA-6); polyundecanamide (PA-11, sold by Arkema under the brand RILSAN^{®}); polylauryllactam (PA-12, also sold by Arkema under the brand RILSAN^{®}); polybutylene adipamide (PA-4,6); polyhexamethylene adipamide (PA-6,6); polyhexamethylene azelamide (PA-6,9); polyhexamethylene sebacamide (PA-6,10); polyhexamethylene dodecanamide (PA-6,12); polydecamethylene dodecanamide (PA-10,12); polydecamethylene sebacamide (PA-10,10) and polydodecamethylene dodecanamide (PA-12,12).

The expression "semicrystalline polyamides" also targets cycloaliphatic homopolyamides.

Mention may especially be made of the cycloaliphatic homopolyamides which result from the condensation of a cycloaliphatic diamine and an aliphatic diacid.

As an example of a cycloaliphatic diamine, mention may be made of 4,4'-methylenebis(cyclohexylamine), also known as *para-*bis(aminocyclohexyl)methane or PACM, 2,2'-dimethyl-4,4'-methylenebis(cyclohexylamine), also known as bis(3-methyl-4-aminocyclohexyl)methane or BMACM.

Thus, among the cycloaliphatic homopolyamides, mention may be made of the polyamides PA-PACM,12 that result from the condensation of PACM with the C 12 diacid, PA-BMACM,10 and PA-BMACM,12 that result from the condensation of BMACM with, respectively, C10 and C12 aliphatic diacids.

The expression "polyamide grafts" also targets the semiaromatic homopolyamides that result from the condensation:
- of an aliphatic diamine and an aromatic diacid, such as terephthalic acid (T) and isophthalic acid (I). The polyamides obtained are then commonly known as "polyphthalamides" or PPAs; and
- of an aromatic diamine, such as xylylenediamine, and more particularly *meta*-xylylenediamine (MXD) and an aliphatic diacid.

Thus, non-limitingly, mention may be made of the polyamides PA-6,T, PA-6,I, PA-MXD,6 or else PA-MXD,10.

The polyamide grafts coming into play in the composition according to the invention can be copolyamides. These result from the polycondensation of at least two of the groups of monomers mentioned above in order to obtain homopolyamides. The term "monomer" in the present description of the copolyamides should be taken in the sense of a "repeat unit". This is because the case where a repeat unit of the PA is formed from the combination of a diacid with a diamine is particular. It is considered that it is the combination of a diamine and a diacid, that is to say the diamine-diacid pair (in an equimolar amount), which corresponds to the monomer. This is explained by the fact that individually, the diacid or the diamine is only one structural unit, which is not enough on its own to polymerize in order to give a polyamide.

Thus, the copolyamides especially cover the condensation products of:
- at least two lactams;
- at least two aliphatic α,ω-aminocarboxylic acids;
- at least one lactam and at least one aliphatic α,ω-aminocarboxylic acid;
- at least two diamines and at least two diacids
- at least one lactam with at least one diamine and at least one diacid;
- at least one aliphatic α,ω-aminocarboxylic acid with at least one diamine and at least one diacid,
the diamine(s) and the diacid(s) possibly being, independently of one another, aliphatic, cycloaliphatic or aromatic.

Depending on the types and ratio of monomers, the copolyamides may be semicrystalline or amorphous. In the case of amorphous copolyamides, only the glass transition temperature is observed, whereas in the case of semicrystalline copolyamides a glass transition temperature and a melting point (which will inevitably be higher) are observed.

Among the amorphous copolyamides that can be used within the context of the invention, mention may be made, for example, of the copolyamides containing semiaromatic monomers.

Among the copolyamides, it is also possible to use semicrystalline copolyamides and particularly those of the PA-6/ 11, PA-6/12 and PA-6/11/12 type.

The degree of polymerization may vary to a large extent; depending on its value it is a polyamide or a polyamide oligomer. Advantageously, the polyamide grafts are monofunctional.

So that the polyamide graft has a monoamine end group, it is sufficient to use a chain limiter of formula: 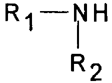 in which:
- R1 is hydrogen or a linear or branched alkyl group containing up to 20 carbon atoms; and
- R2 is a group having up to 20 carbon atoms that is a linear or branched alkyl or alkenyl group, a saturated or unsaturated cycloaliphatic radical, an aromatic radical or a combination of the preceding. The limiter may be, for example, laurylamine or oleylamine.

So that the polyamide graft has a carboxylic monoacid end group, it is sufficient to use a chain limiter of formula R'1-COOH, R'1-CO-O-CO-R'2 or a carboxylic diacid.

R'1 and R'2 are linear or branched alkyl groups containing up to 20 carbon atoms.

Advantageously, the polyamide graft has one end group having an amine functionality. The preferred monofunctional polymerization limiters are laurylamine and oleylamine.

Advantageously, the polyamide grafts have a molecular weight between 1000 and 5000 g/mol and preferably between 2000 and 3000 g/mol.

The polycondensation defined above is carried out according to the commonly known processes, for example at a temperature generally between 200 and 300°C, under vacuum or in an inert atmosphere, with stirring of the reaction mixture. The average chain length of the graft is determined by the initial molar ratio between the polycondensable monomer or the lactam and the monofunctional polymerization limiter. For the calculation of the average chain length, one chain limiter molecule is usually counted per one graft chain.

A person skilled in the art will only have to select the types and ratio of monomers and also choose the molecular weights of the polyamide grafts in order to be able to easily obtain the desired values of the glass transition temperature and optionally the melting point. Advantageously, the glass transition temperature or melting point is above 130°C, more advantageously from 140 to 350°C, preferably from 150 to 300°C, most preferably from 190 to 275°C. A person skilled in the art can easily measure the melting point and glass transition temperature of the polyamide grafts and of the other polymers by differential scanning calorimetry, commonly known as DSC, using a heating rate of 10°C per minute.

The condensation reaction of the polyamide graft on the polyolefin backbone containing the residue of (X) is carried out by reaction of one amine or acid functional group of the polyamide graft with the residue of (X). Advantageously, monoamine polyamide grafts are used and amide or imide bonds are created by reacting the amine functional group with the functional group of the residue of (X). This condensation is preferably carried out in the melt state. To manufacture the polyamide-grafted polymer according to the invention, it is possible to use conventional mixing and/or extrusion techniques. The components of the composition are thus blended to form a "compound" which may optionally be granulated on exiting the die.

To obtain the composition, it is possible to blend the polyamide graft and the backbone in an extruder at a temperature generally between 200 and 300°C. The average residence time of the molten material in the extruder may be between 5 seconds and 5 minutes, and preferably between 20 seconds and 1 minute. The efficiency of this condensation reaction may be evaluated by selective extraction of free polyamide grafts, that is to say those that have not reacted to form the polyamide-grafted polymer.

The preparation of polyamide grafts having an amine end group and also their addition to a polyolefin backbone containing the residue of (X) is described in Patents US 3 976 720, US 3 963 799, US 5 342 886 and FR 2 291 225.

The polyamide-grafted polymer of the present invention advantageously has a nanostructured organization. To obtain this type of organization, use will preferably be made, for example, of grafts having a number-average molecular weight Mₙ between 1000 and 5000 g/mol and more preferably between 2000 and 3000 g/mol. Use will also most preferably be made of between 20 and 40%, or even of 25 to 35%, by weight of polyamide grafts and a number of monomers (X) attached, on average, to the polyolefin backbone within the range from 1.3 to 10.

The composition may comprise a polyamide-grafted polymer blend as defined previously.

The composition comprises, relative to its total weight, advantageously at least 25%, preferably at least 50% and more preferably still at least 75% by weight of polyamide-grafted polymer.

According to the invention, the composition of the protective film on the back of the photovoltaic module may contain, in addition, at least one complementary polymer different from the polyolefin backbone and from the polyamide graft. Preferably, a polymer that is miscible or partially miscible with the polyamide-grafted polymer is used. A person skilled in the art knows how to choose the polymers that are miscible or partially miscible with the polyamide-grafted polymer. Preferably, this additional polymer is chosen from polyolefins and polyamides. For example, it is possible to use a polyolefin or a polyamide of the same type, but having a number-average molecular weight different from that used to produce the polyamide-grafted polymer. By adding a polyolefin, it is advantageously possible to reduce the water vapour permeability of the film according to the invention. By adding a polyamide, it is advantageously possible to increase the thermomechanical strength of the film. The polyolefin may be chosen from the polyolefins described previously; it is preferably a homopolymer of ethylene or a copolymer of ethylene and a second α-olefin, of which the amount by weight of ethylene in the copolymer is greater than or equal to 90%. The complementary polyamide may be chosen from the polyamides described previously; it may be chosen from homopolyamides such as PA-6, PA-6,6, PA-11 and PA-12 and copolyamides, such as PA-6/11, PA-6 / 12 and PA-6/11/12. Advantageously, the amount by weight of this additional polymer is less than or equal to 50%, preferably from 5 to 35%, relative to the total weight of the composition.

The composition of the protective backsheet film of the photovoltaic module may contain additives, the nature and amounts of which a person skilled in the art easily knows how to select in order to obtain the desired properties of the composition.

Although crosslinking is not essential, the latter is possible for further improving the thermomechanical properties of the protective film. It is therefore not outside the scope of the invention if crosslinking agents are added. Mention may be made, as examples, of isocyanates or organic peroxides. This crosslinking may also be carried out by known irradiation techniques.

Coupling agents may advantageously be added in order to improve the tack of the composition when this must be particularly high. According to the invention, the coupling agent is a non-polymeric ingredient; it may be organic, mineral and more preferably semi-mineral and semi-organic. Among these, mention may be made of organic silanes or titanates, such as for example monoalkyl titanates, trichlorosilanes and trialkoxysilanes.

Since UV radiation leads to yellowing of the encapsulant, UV stabilizers may be added in order to ensure the transparency of the encapsulant during its service life. These compounds may be, for example, based on benzophenone or benzotriazole. They can be added in amounts below 10%, and preferably from 0.1 to 5%, by weight of the total weight of the composition. The UV stabilizers are generally within proportions ranging from 0.05% to 2% by weight of the composition.

Antioxidants may also be used to limit the degradation of the film over time and during the conversion of the composition. These antioxidants may be chosen from phosphites or phenolics. They are generally within proportions ranging from 0.05% to 2% by weight of the composition.

Fillers, in particular mineral fillers, may be added to improve the thermomechanical strength of the composition. Non-limitingly, mention may be made of silica, modified or unmodified clays, alumina or calcium carbonates and also carbon nanotubes, as examples.

Plasticizers may be added in order to facilitate processing and improve the productivity of the process for manufacturing the composition and the structures. Mention may be made, as examples, of paraffinic, aromatic or naphthalenic mineral oils which also make it possible to improve the tack of the composition according to the invention. Mention may also be made, as a plasticizer, of phthalates, azelates, adipates, and tricresyl phosphate.

Flame retardant agents may also be added. These agents may be halogenated or non-halogenated. Among the halogenated agents, mention may be made of brominated products. Use may also be made, as a non-halogenated agent, of additives based on phosphorus such as ammonium phosphate, polyphosphate, phosphinate or pyrophosphate, melamine cyanurate, pentaerythritol, zeolites and also mixtures of these agents. The composition may comprise these agents in proportions ranging from 3 to 40% relative to the total weight of the composition.

It is also possible to add dyestuffs or brighteners in proportions generally ranging from 5 to 15% relative to the total weight of the composition.

The composition comprises preferably pigments such as, for example, titanium dioxide; these pigments can provide better reflection of the incoming light, which allows the increase the quantity of electricity that can be produced by the photovoltaic module.

All these additives may be added directly to the composition or be added in the form of a masterbatch.

The protective film may have a thickness ranging from 50 µm to 2000 µm and more preferably still from 100 µm to 750 µm. This film may be a single-layer or multilayer film.

For the single-layer film, it is formed from one layer of composition (cPgP) comprising the polyamide-grafted polymer as described previously. Among the advantages of this single-layer film, mention may be made of the fact that no adhesive is necessary for its manufacture, unlike the multilayer fluoropolymer/polyester/fluoropolymer or EVA/ polyester/ fluoropolymer films.

For the multilayer film, it is possible, for example, to join to the layer of the composition cPgP, one or two other layers known as a "support layer". This support layer possibly comprising polymers such as polyamides, polyesters and fluoropolymers such as polyvinyl fluoride PVF or polyvinylidene fluoride PVDF. Mention may also be made, as another support, of glasses or metals. It is also possible to use adhesives between the various layers of the multilayer film.

As examples of a multilayer film, mention may be made of those comprising the following structure:
- cPgP/ adhesive / fluoropolymer;
- cPgP/adhesive/PET;
- cPgP with flame retardant agent/ cPgP without flame retardant agent; and
- cPgP without flame retardant agent/ cPgP with flame retardant agent/ cPgP without flame retardant agent.

The protective films or the layers of protective films may be obtained from the composition described previously by the conventional techniques of press moulding, injection moulding, tubular (bubble) extrusion-blow moulding, extrusion-lamination, extrusion-coating, flat-film extrusion (also called extrusion casting) or else extrusion by calendering, all these structures possibly being optionally thermoformed afterwards. Preferably, the tubular (bubble) extrusion-blow moulding and flat-film extrusion techniques are used.

The protective film may be surface modified by plasma discharge techniques, by example a corona treatment, which are techniques known from the man skilled in the art. The protective film may also be covered with adhesive for improving the adhesion with other layers.

The invention also relates to a process of manufacturing a photovoltaic module comprising a step of assembling its various constituent layers, of which the layer at the back of the module is the protective film described previously. To manufacture the photovoltaic module according to the invention, a step of assembling its various layers is carried out by any type of assembly technique, such as press moulding, for example, hot pressing, vacuum pressing or lamination, in particular thermal lamination. The manufacturing conditions will be easily determined by a person skilled in the art by adjusting the temperature and the pressure applied to the photovoltaic module. This assembly step may advantageously comprise a stage of laminating the layers. For example, it is possible to place successively on the protective film layer, a lower first encapsulant layer, a photovoltaic cell, an upper second encapsulant layer, then an upper protective layer. These various layers are assembled to form the module. Advantageously, the laminating temperature is below the melting point or glass transition temperature of the polyamide grafts. Preferably, when the polyolefin is semicrystalline, the laminating temperature is above the melting point of the polyolefin. These layers may then be laminated at a temperature within the range from 80 to 250°C, preferably at a temperature below 150°C.

Advantageously, during the manufacture of the photovoltaic module, the protective backsheet film layer, which is brought into direct contact with the encapsulant, is a cPgP layer.

To form the photovoltaic cell, it is possible to use any type of photovoltaic sensor, among which the sensors known as "conventional" sensors based on doped single-crystal or polycrystalline silicon; the thin-film type sensors formed, for example, from amorphous silicon, from cadmium telluride, from copper-indium diselenide or from organic materials may also be used.

As examples of encapsulant that can be used in the photovoltaic modules according to the invention, mention may be made, non-exhaustively, of the films based on an ethylene-based ionomer or copolymer such as EVA or ethylene/alkyl (meth)acrylate copolymers. The upper protective sheet has abrasion-resistance and impact-resistance properties, is transparent and protects the photovoltaic sensors from outside moisture. To form this layer, mention may be made of glass, PMMA or any other polymer composition combining these characteristics.

In order to manufacture the solar modules according to the invention, a person skilled in the art may refer, for example, to the Handbook of Photovoltaic Science and Engineering, Wiley, 2003.

The present invention will now be illustrated by particular exemplary embodiments described below. It is specified that these examples in no way aim to limit the scope of the present invention.

### Examples

To produce films according to the invention, the following products were used:
LOTADER^{®} 4210: Copolymer of ethylene, ethyl acrylate (6.5 wt%) and maleic anhydride (3.6 wt%) produced by Arkema having an MFI of 9 g/10 min (190°C/2.16 kg measured according to ASTM D 1238). PA-6: Monofunctionalized primary amine polyamide of caprolactam, it had a number-average molecular weight of 2500 g/mol and had a Tₘ equal to 220°C.
PA-11: Monofunctionalized primary amine polyamide of 11-aminoundecanoic acid, it had a number-average molecular weight of 2500 g/mol and had a Tₘ equal to 220°C.
MM PIGMENT: Polyethylene-based masterbatch comprising 70% by weight of TiO₂.

### ANTIOXIDANT

### UV STABILIZER

ERACLENE^{®} ML 70: High-density PE produced by Polimeri Europa.

The compositions produced to form the films according to the invention (EX1 to EX4) and also their weight ratios are given in Table 1.

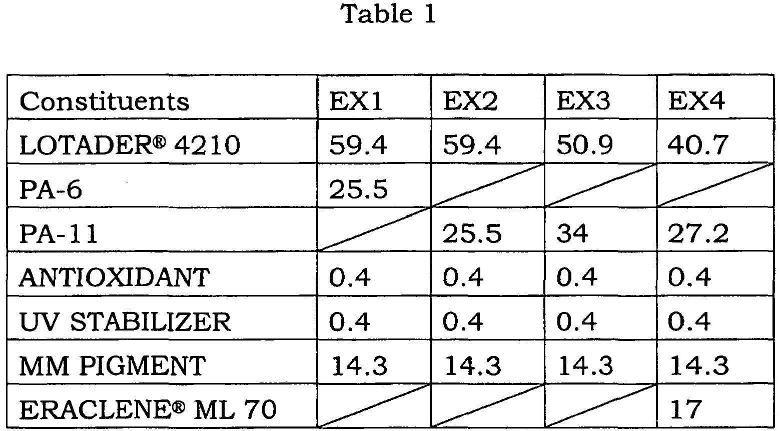

These compositions were extruded using a Werner 40 type extruder, the screw speed being 300 rpm, the temperature 260°C and the throughput 80 kg/h.

In order to evaluate the properties of the films, the films were manufactured from compositions 1 to 6 having a thickness of 300 µm by extrusion-casting on a Collin 45 extrusion line. The extrusion temperature was 240°C, the line speed 5 m/min and the screw speed 65 rpm.

In order to show the advantageous properties of the films according to the invention, the various evaluation tests were carried out with a comparative protective film (CP) having a thickness of 175 µm, which had the structure: PVF (37µm)/PET (100µm)/PVF (37µm) manufactured by Isovolta and sold under the trademark TPT^{®}.

The water vapour permeation was measured according to the ASTM E96 E method (23°C/85% relative humidity). The permeation values of the various films EX1 to EX4 and of the comparative film CP are given in Table 2.

Photovoltaic modules were also manufactured in order to evaluate their resistance to UV radiation and to heat. In order to manufacture these modules, a sheet of glass, a first layer of EVA-based encapsulant, a photovoltaic sensor, a second layer of EVA-based encapsulant and the film according to the invention were successively positioned. A module was obtained after press moulding at 150°C for 20 minutes.

The heat resistance was evaluated by colorimetric data. The modules were placed in chambers at 85°C, 85% relative humidity for 2000 h. The difference in colour (relative to its initial colour) was measured according to the ASTM D1003 standard with an illuminant C at 2° and the yellowness index measured according to the ASTM D 1925 standard at the end of the ageing. The difference in colour corresponded to the difference in colour between the initial colour and the colour after ageing. The difference in colour and the yellowness index were measured by placing the illuminant on the glass side. The difference in colour and the yellowness index measured under these conditions made it possible to determine the yellowing of the layer of encapsulant between the glass and the backsheet layer. The results obtained are also given in Table 2.

The electrical volume resistivity was determined at 20°C using a Novocontrol Concept 40 dielectric spectrometer. A frequency sweep was carried out between 0.01 Hz and 10⁶ Hz and the low-frequency (0.01 Hz) resistivity of the samples was recorded when this resistivity barely changed with the frequency.

**Table 2**

| Examples | Water vapour permeation (23°C/85%RH) (g/m² · 24 h) | Delta E (after 2000 h at 85°C/85%RH) | Yellowness index (after 2000 h at 85°C/85%RH) | Volume resistivity at 10⁻² Hz (Ω · cm) |
|---|---|---|---|---|
| EX1 | 2.4 | 3.4 | 8.0 | Not measured |
| EX2 | 1.9 | 5.6 | Not measured | 2 · 10¹⁴ |
| EX3 | 2.3 | 4.6 | 10.6 | 2 · 10¹⁴ |
| EX4 | 1.6 | 5.2 | Not measured | 3 · 10¹⁴ |
| CP | 2.1 | 6.0 | 12 | 9 · 10¹³ |

Furthermore, the films produced have a very good adhesion to the conventionally used encapsulants (for example, EVA).

The UV radiation resistance of the modules according to the invention is also very satisfactory.

Furthermore, the breakdown voltage of the films according to the invention was also measured and this is equivalent to that of the PVF/ PET/ PVF film.

All these combined features make it possible to obtain photovoltaic modules having highly advantageous properties.

The resistance to humid heat of the examples of modules with films according to the invention EX1 to EX4 is particularly high and is even greater than that of the comparative module. Furthermore, the volume resistivity of the examples according to the invention is also better than that of the comparative fluoropolymer-based film. In particular, EX4 has particularly advantageous water vapour permeation properties.

## Claims

1. Photovoltaic module (20), comprising:
- one or more photovoltaic cells (12; 10) encased in an encapsulant (22),
- an upper protective layer (24), and
- a protective backsheet film (26),
**characterized in that** the protective backsheet film (26) is a film comprising at least one layer of a composition comprising at least one polyamide-grafted polymer, wherein the polyamide-grafted polymer comprises a polyolefin backbone containing a residue of at least one unsaturated monomer (X) and at least one polyamide graft, in which:
■ the residue of the unsaturated monomer (X) is attached to the backbone by grafting or copolymerization;
■ the residue of the unsaturated monomer (X) comprises a functional group capable of reacting via a condensation reaction with a polyamide having at least one amine end group and/or at least one carboxylic acid end group;
■ the polyamide graft is attached to the polyolefine backbone by the residue of the unsaturated monomer (X);
■ the polyamide graft comprises at least one amine and/or carboxylic acid functional group;
■ one amine or acid functional group of the polyamide graft having reacted via a condensation reaction with the residue (X);
the polyamide-grafted polymers comprising, relative to their total weight:
■ 40 to 95% by weight of the polyolefin backbone comprising the unsaturated monomer (X); and
• 5 to 60% by weight of polyamide grafts,
and the melting point or glass transition temperature of the polyamide grafts being greater than or equal to 85°C.

2. Photovoltaic module (20) according to claim 1, **characterized in that** the unsaturated monomer (X) comprises an acid anhydride functional group.

3. Photovoltaic module (20) according to claim 1 or 2, **characterized in that** at least some of the polyamide grafts are monofunctionalized primary amines.

4. Photovoltaic module (20) according to any of claims 1 to 3, **characterized in that** the polyamide-grafted polymer comprises 20 to 40% by weight of polyamide grafts, based on its total weight.

5. Photovoltaic module (20) according to any of claims 1 to 4, **characterized in that** the melting point of the polyamide grafts is within the range of 140 to 350°C.

6. Photovoltaic module (20) according to any of claims 1 to 5, **characterized in that** the number-average molecular weight of the polyamide grafts is within the range of 1000 to 5000 g/mol, preferably within the range of 2000 to 3000 g/mol.

7. Photovoltaic module (20) according to any of claims 1 to 6, **characterized in that** the number of unsaturated monomers (X) attached to the polyolefin backbone is greater than or equal to 1.3 and less than or equal to 10.

8. Photovoltaic module (20) according to any of claims 1 to 7, **characterized in that** the polyolefin backbone is a copolymer comprising an unsaturated monomer (X).

9. Photovoltaic module (20) according to any of claims 1 to 8, **characterized in that** the polyolefin backbone is an ethylene/alkyl (meth)acrylate copolymer comprising an unsaturated monomer (X).

10. Photovoltaic module (20) according to any of claims 1 to 9, **characterized in that** the polyamide-grafted polymer has a nanostructured organization.

11. Photovoltaic module (20) according to any of claims 1 to 10, **characterized in that** it comprises a polyamide-grafted polymer blend.

12. Photovoltaic module (20) according to any of claims 1 to 11, **characterized in that** the composition is nanostructured.

13. Photovoltaic module (20) according to any of claims 1 to 12, **characterized in that** the composition further comprises a complementary polymer selected from polyolefins and polyamides, which is different from the polyolefin backbone and from the polyamide graft.

14. Photovoltaic module (20) according to any of claims 1 to 13, **characterized in that** the composition comprises at least 50% by weight of polyamide-grafted polymer.

15. Photovoltaic module (20) according to any of claims 1 to 14, **characterized in that** the protective backsheet film (26) is a multilayer film comprising at least one layer of the composition.

16. Photovoltaic module (20) according to any of claims 1 to 15, **characterized in that** the protective backsheet film (26) is in direct contact with the encapsulant (22) comprising a polyolefin.

17. Process of manufacturing a photovoltaic module (20) according to any of claims 1 to 16, comprising a step of assembling the various layers (22, 24, 26) that constitute the module, at least one of these layers being a protective backsheet film (26) as defined in any of claims 1 to 16.

18. Use of a photovoltaic module according to any of claims 1 to 16 under a source of radiation for producing electricity.

## Patentansprüche

1. Photovoltaikmodul (20), das Folgendes aufweist:
- eine oder mehrere Solarzellen (12; 10), die von einem Einkapselungsmaterial (22) umhüllt sind,
- eine obere Schutzschicht (24), und
- eine Rückseitenschutzfolie (26),
**dadurch gekennzeichnet, dass** die Rückseitenschutzfolie (26) eine Folie ist, die zumindest eine Schicht einer Zusammensetzung aufweist, die zumindest ein Polyamid-gepfropftes Polymer enthält, wobei das Polyamid-gepfropfte Polymer ein Polyolefin-Grundgerüst, das einen Rest zumindest eines ungesättigten Monomers (X) aufweist, und zumindest einen Polyamid-Pfropfzweig umfasst, worin:
■ der Rest des ungesättigten Monomers (X) an dem Grundgerüst durch Pfropfung oder Copolymerisation angebracht ist;
■ der Rest des ungesättigten Monomers (X) eine funktionelle Gruppe aufweist, die befähigt ist, über eine Kondensationsreaktion mit einem Polyamid zu reagieren, das mindestens eine endständige Aminogruppe und/oder mindestens eine endständige Carbonsäuregruppe aufweist;
■ der Polyamid-Pfropfzweig über den Rest des ungesättigten Monomers (X) an dem Grundgerüst angebracht ist;
■ der Polyamid-Pfropfzweig zumindest eine funktionelle Aminogruppe und/oder funktionelle Carbonsäuregruppe aufweist;
■ eine funktionelle Aminogruppe oder funktionelle Carbonsäuregruppe des Polyamid-Pfropfzweigs über eine Kondensationsreaktion mit dem Rest (X) reagiert hat;
wobei die Polyamid-gepfropften Polymere, bezogen auf ihr Gesamtgewicht, enthalten:
■ 40 bis 95 Gew.-% des Polyolefin-Grundgerüsts, das das ungesättigte Monomer (X) aufweist; und
■ 5 bis 60 Gew.-% Polyamid-Pfropfzweige,
und der Schmelzpunkt oder die Glasübergangstemperatur der Polyamid-Pfropfzweige größer oder gleich 85°C ist.

2. Photovoltaikmodul (20) nach Anspruch 1, **dadurch gekennzeichnet, dass** das ungesättigte Monomer (X) eine funktionelle Säureanhydridgruppe aufweist.

3. Photovoltaikmodul (20) nach Anspruch 1 oder 2, **dadurch gekennzeichnet, dass** zumindest einige der Polyamid-Pfropfzweige monofunktionalisierte primäre Amine sind.

4. Photovoltaikmodul (20) nach einem der Ansprüche 1 bis 3, **dadurch gekennzeichnet, dass** das Polyamid-gepfropfte Polymer, bezogen auf sein Gesamtgewicht, 20 bis 40 Gew.-% Polyamid-Pfropfzweige enthält.

5. Photovoltaikmodul (20) nach einem der Ansprüche 1 bis 4, **dadurch gekennzeichnet, dass** der Schmelzpunkt der Polyamid-Pfropfzweige im Bereich von 140 bis 350°C liegt.

6. Photovoltaikmodul (20) nach einem der Ansprüche 1 bis 5, **dadurch gekennzeichnet, dass** die zahlenmittlere Molmasse der Polyamid-Pfropfzweige im Bereich von 1000 bis 5000 g/mol und vorzugsweise im Bereich von 2000 bis 3000 g/mol liegt.

7. Photovoltaikmodul (20) nach einem der Ansprüche 1 bis 6, **dadurch gekennzeichnet, dass** die Zahl der an das Polyolefin-Grundgerüst gebundenen ungesättigten Monomere (X) größer oder gleich 1,3 und kleiner oder gleich 10 ist.

8. Photovoltaikmodul (20) nach einem der Ansprüche 1 bis 7, **dadurch gekennzeichnet, dass** das Polyolefin-Grundgerüst ein Copolymer ist, das ein ungesättigtes Monomer (X) umfasst.

9. Photovoltaikmodul (20) nach einem der Ansprüche 1 bis 8, **dadurch gekennzeichnet, dass** das Polyolefin-Grundgerüst ein Ethylen/Alkyl(meth)acrylat-Copolymer ist, das ein ungesättigtes Monomer (X) umfasst.

10. Photovoltaikmodul (20) nach einem der Ansprüche 1 bis 9, **dadurch gekennzeichnet, dass** das Polyamid-gepfropfte Polymer eine nanostrukturierte Organisation aufweist.

11. Photovoltaikmodul (20) nach einem der Ansprüche 1 bis 10, **dadurch gekennzeichnet, dass** es eine Polyamid-gepfropfte Polymermischung aufweist.

12. Photovoltaikmodul (20) nach einem der Ansprüche 1 bis 11, **dadurch gekennzeichnet, dass** die Zusammensetzung nanostrukturiert ist.

13. Photovoltaikmodul (20) nach einem der Ansprüche 1 bis 12, **dadurch gekennzeichnet, dass** die Zusammensetzung ferner ein ergänzendes Polymer aufweist, das unter den Polyolefinen und Polyamiden ausgewählt ist, wobei es sich von dem Polyolefin-Grundgerüst und dem Polyamid-Pfropfzweig unterscheidet.

14. Photovoltaikmodul (20) nach einem der Ansprüche 1 bis 13, **dadurch gekennzeichnet, dass** die Zusammensetzung mindestens 50 Gew.-% Polyamid-gepfropftes Polymer enthält.

15. Photovoltaikmodul (20) nach einem der Ansprüche 1 bis 14, **dadurch gekennzeichnet, dass** die Rückseitenschutzfolie (26) eine Mehrschichtfolie ist, die zumindest eine Schicht der Zusammensetzung enthält.

16. Photovoltaikmodul (20) nach einem der Ansprüche 1 bis 15, **dadurch gekennzeichnet, dass** die Rückseitenschutzfolie (26) in direktem Kontakt mit dem Einkapselungsmaterial (22) ist, das ein Polyolefin enthält.

17. Verfahren zur Herstellung eines Photovoltaikmoduls nach einem der Ansprüche 1 bis 16, das einen Schritt umfasst, die verschiedenen Lagen (22, 24, 26), die das Modul bilden, zusammenzusetzen, wobei mindestens eine der Lagen eine Rückseitenschutzfolie (26) ist, wie sie einem der Ansprüche 1 bis 16 definiert ist.

18. Verwendung eines Photovoltaikmoduls nach einem der Ansprüche 1 bis 16 unter einer Strahlungsquelle zur Erzeugung von Elektrizität.

## Revendications

1. Module photovoltaïque (20), comprenant :
- une ou plusieurs cellules photovoltaïques (12 ; 10) enrobé(es) d'un agent d'encapsulation (22) ;
- une couche de protection supérieure (24) et
- un film de protection arrière (26),
**caractérisé en ce que** le film de protection arrière (26) est un film comprenant au moins une couche d'une composition comprenant au moins un polymère greffé à base de polyamide, dans lequel le polymère greffé à base de polyamide comprend un squelette polyoléfine contenant un résidu d'au moins un monomère insaturé (X) et au moins un greffon polyamide, dans lequel :
■ le résidu du monomère insaturé (X) est fixé au squelette par greffage ou copolymérisation ;
■ le résidu du monomère insaturé (X) comprend un groupement fonctionnel capable de réagir par le biais d'une réaction de condensation avec un polyamide ayant au moins un groupe terminal amine et/ou au moins un groupe terminal acide carboxylique ;
■ le greffon polyamide est fixé au squelette polyoléfine par le résidu du monomère insaturé (X) ;
■ le greffon polyamide comprend au moins un groupement fonctionnel amine et/ou acide carboxylique ;
■ un groupement fonctionnel amine ou acide du greffon polyamide ayant réagi par le biais d'une réaction de condensation avec le résidu (X) ;
les polymères greffés à base de polyamide comprenant, sur la base de leur poids total :
■ 40 à 95 % en poids du squelette polyoléfine comprenant le monomère insaturé (X) ; et
■ 5 à 60 % en poids de greffons polyamide,
et le point de fusion ou la température de transition vitreuse des greffons polyamide étant supérieur(e) ou égal(e) à 85 °C.

2. Module photovoltaïque (20) selon la revendication 1, **caractérisé en ce que** le monomère insaturé (X) comprend un groupement fonctionnel anhydride d'acide.

3. Module photovoltaïque (20) selon la revendication 1 ou 2, **caractérisé en ce qu'**au moins certains greffons polyamide sont des amines primaires monofonctionnalisées.

4. Module photovoltaïque (20) selon l'une quelconque des revendications 1 à 3, **caractérisé en ce que** le polymère greffé à base de polyamide comprend 20 à 40 % en poids de greffons polyamide, sur la base de son poids total.

5. Module photovoltaïque (20) selon l'une quelconque des revendications 1 à 4, **caractérisé en ce que** le point de fusion des greffons polyamide se situe dans la gamme allant de 140 à 350 °C.

6. Module photovoltaïque (20) selon l'une quelconque des revendications 1 à 5, **caractérisé en ce que** le poids moléculaire moyen en nombre des greffons polyamide se situe dans la gamme allant de 1 000 à 5 000 g/mol, de préférence dans la gamme allant de 2 000 à 3 000 g/mol.

7. Module photovoltaïque (20) selon l'une quelconque des revendications 1 à 6, **caractérisé en ce que** le nombre de monomères insaturés (X) fixés au squelette polyoléfine est supérieur ou égal à 1,3 et inférieur ou égal à 10.

8. Module photovoltaïque (20) selon l'une quelconque des revendications 1 à 7, **caractérisé en ce que** le squelette polyoléfine est un copolymère comprenant un monomère insaturé (X).

9. Module photovoltaïque (20) selon l'une quelconque des revendications 1 à 8, **caractérisé en ce que** le squelette polyoléfine est un copolymère d'éthylène/de (méth)acrylate d'alkyle comprenant un monomère insaturé (X).

10. Module photovoltaïque (20) selon l'une quelconque des revendications 1 à 9, **caractérisé en ce que** le polymère greffé à base de polyamide est organisé en nanostructures.

11. Module photovoltaïque (20) selon l'une quelconque des revendications 1 à 10, **caractérisé en ce qu'**il comprend un mélange de polymères greffés à base de polyamide.

12. Module photovoltaïque (20) selon l'une quelconque des revendications 1 à 11, **caractérisé en ce que** la composition est organisée en nanostructures.

13. Module photovoltaïque (20) selon l'une quelconque des revendications 1 à 12, **caractérisé en ce que** la composition comprend en outre un polymère complémentaire choisi parmi les polyoléfines et les polyamides, qui est différent du squelette polyoléfine et du greffon polyamide.

14. Module photovoltaïque (20) selon l'une quelconque des revendications 1 à 13, **caractérisé en ce que** la composition comprend au moins 50 % en poids de polymère greffé à base de polyamide.

15. Module photovoltaïque (20) selon l'une quelconque des revendications 1 à 14, **caractérisé en ce que** le film de protection arrière (26) est un film multicouche comprenant au moins une couche de la composition.

16. Module photovoltaïque (20) selon l'une quelconque des revendications 1 à 15, **caractérisé en ce que** le film de protection arrière (26) est en contact direct avec l'agent d'encapsulation (22) comprenant une polyoléfine.

17. Procédé de fabrication d'un module photovoltaïque (20) selon l'une quelconque des revendications 1 à 16, comprenant une étape d'assemblage des différentes couches (22, 24, 26) qui constituent le module, au moins l'une de ces couches étant un film de protection arrière (26) tel que défini dans l'une quelconque des revendications 1 à 16.

18. Utilisation d'un module photovoltaïque selon l'une quelconque des revendications 1 à 16 sous une source de rayonnement pour produire de l'électricité.
